Europäisches Patentamt

European Patent Office

Office européen des brevets

(19)

(11) Numéro de publication: **0 364 334**
**A1**

(12) **DEMANDE DE BREVET EUROPEEN**

(21) Numéro de dépôt: 89402724.2

(22) Date de dépôt: 03.10.89

(51) Int. Cl.5: **F16L 59/14 , F16L 59/16 , H05K 9/00 , F17C 13/00**

(30) Priorité: 11.10.88 FR 8813341

(43) Date de publication de la demande:
18.04.90 Bulletin 90/16

(84) Etats contractants désignés:
**DE GB NL**

(71) Demandeur: THOMSON-CSF
51, Esplanade du Général de Gaulle
F-92800 Puteaux(FR)

(72) Inventeur: Gillard, Jean-Claude
THOMSON-CSF SCPI Cédex 67
F-92045 Paris la Défense(FR)
Inventeur: Librizzi, Gilbert
THOMSON-CSF SCPI Cédex 67
F-92045 Paris la Défense(FR)

(74) Mandataire: Courtellemont, Alain et al
THOMSON-CSF SCPI
F-92045 PARIS LA DEFENSE CEDEX 67(FR)

(54) Dispositif de transfert de fluide avec protection radioélectrique, et enceinte dont la paroi est traversée par au moins un tel dispositif.

(57) Le dispositif est destiné à permettre le passage d'un fluide, qui peut être à température très différente de la température ambiante, à travers une ouverture (2) pratiquée dans une paroi (1), tout en rendant ouverture radioélectriquement étanche.

Pour cela les problèmes dus à la température du fluide sont traités par l'utilisation de deux conduits coaxiaux (3, 4) séparés par un isolant thermique (6), le fluide circulant dans le conduit intérieur (3). La protection radioélectrique est obtenue par une cloison conductrice étanche (4, 5) allant du conduit intérieur (3) jusqu'aux bords de l'ouverture (2)

Application aux enceintes du type cage de Faraday.

FIG_1

## Dispositif de transfert de fluide, avec protection radioeléctrique, et enceinte dont la paroi est traversée par au moins un tel dispositif

La présente invention concerne un dispositif qui est associé à une ouverture pratiquée dans la paroi extérieure d'une enceinte du type cage de Faraday de telle façon qu'un fluide puisse passer par cette ouverture mais que l'ouverture présente une bonne étanchéité radioélectrique. L'invention s'applique en particulier, mais pas uniquement, aux cas où le fluide en circulation est à une température très différente de la température ambiante.

Il existe des dispositifs connus dans lesquels une sorte de cheminée remplie de paille de fer entoure l'ouverture tandis qu'un conduit, dans lequel circule le fluide, traverse la cheminée et l'ouverture. Ces dispositifs ne répondent pas efficacement aux exigences de continuité électrique et d'atténuation électromagnétique et ne répondent pas du tout aux problèmes de circulation de fluides à très haute ou à très basse température, comme l'azote liquide ; en effet, dans ces cas de très forte différence de température avec le milieu ambiant, soit le conduit est en matériau isolant et il est rapidement détérioré, soit le conduit est métallique et des ponts thermiques, une condensation importante, etc... apparaissent.

Il existe d'autres dispositifs dans lesquels la cheminée remplie de paille de fer est remplacée par un manchon formé par un tronçon de guide d'onde solidaire des parois de l'ouverture ; le manchon entoure le conduit et produit un affaiblissement au dessous de sa fréquence de coupure ; ces dispositifs présentent les mêmes inconvénients que les dispositifs précédemment mentionnés.

Il existe également des dispositifs où le conduit, réalisé en métal, est soudé sur les contours de l'ouverture qu'il traverse ; si la protection radioélectrique est assez bonne, les problèmes thermiques dont il a été question plus avant sont très importants et donc très gênants.

La présente invention a pour but d'éviter ou, pour le moins, de réduire les inconvénients dont il vient d'être question.

Ceci est obtenu principalement grâce à deux conduits coaxiaux séparés par un isolant thermique et grâce à une cloison conductrice continue allant du conduit intérieur jusqu'aux bords de l'ouverture.

Selon l'invention, il est proposé un dispositif de transfert de fluide à travers une ouverture percée dans la paroi extérieure d'une enceinte, avec protection radioélectrique de l'intérieur de l'enceinte, caractérisé par un conduit extérieur et un conduit intérieur au moins sensiblement coaxiaux, le conduit intérieur étant conducteur et servant à la circulation du fluide, par un matériau thermiquement isolant, intercalé entre les deux conduits, et par une cloison radioélectriquement étanche allant des bords de l'ouverture jusqu'au conduit intérieur et comportant une séparation disposée transversalement entre les deux conduits pour diviser en deux zones distinctes la région située entre les deux conduits.

La présente invention sera mieux comprise et d'autres caractéristiques apparaîtront à aide de la description ci-après et des figures s'y rapportant qui représentent

- la figure 1, une vue schématique, en coupe longitudinale, d'un dispositif selon l'invention,

- la figure 2, une vue partielle schématique, en coupe longitudinale, d'un autre dispositif selon l'invention.

Sur les figures les éléments correspondants sont désignés par les mêmes repères et les échelles ne sont pas toujours respectées pour faciliter la compréhension.

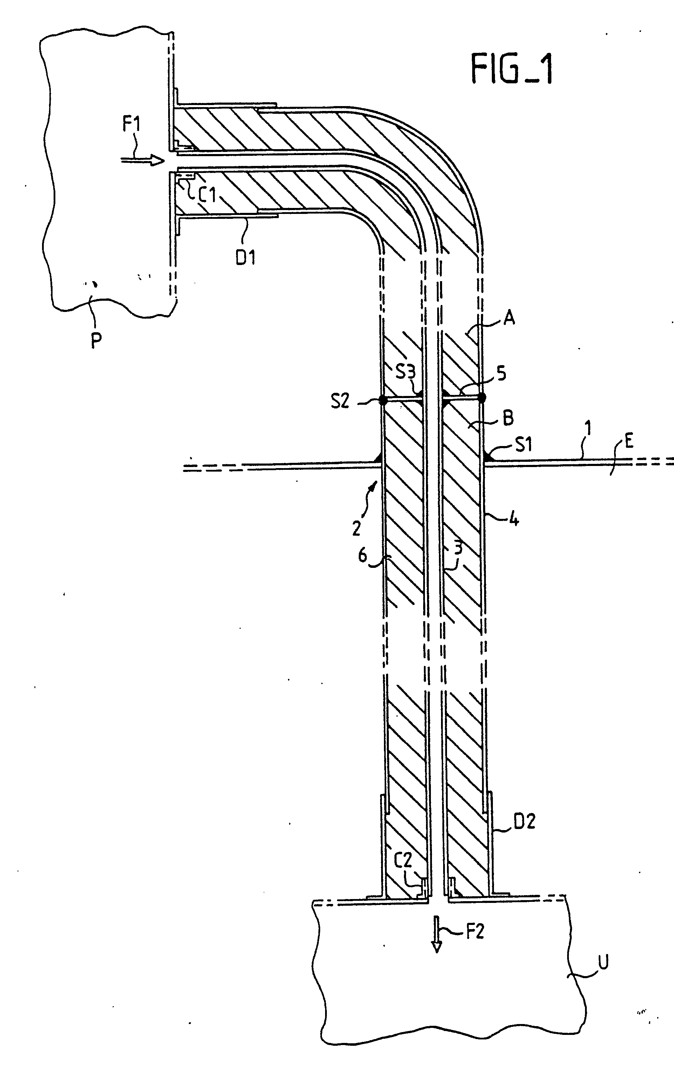

La figure 1 représente, en coupe longitudinale, une première réalisation d'un dispositif de transfert selon l'invention. Ce dispositif est destiné à acheminer de l'azote liquide depuis une pompe, P, située à l'extérieur d'une enceinte E, jusqu'à un appareil, U, disposé à l'intérieur de l'enceinte. L'enceinte E présente une paroi extérieure 1 percée d une ouverture 2 à travers laquelle pas sent deux conduits coaxiaux en cuivre ; un conduit intérieur 3 et un conduit extérieur 4 séparés par un isolant thermique 6 ; le conduit intérieur est un tube de 14 mm de diamètre intérieur et le conduit extérieur est un tube de 120 mm de diamètre extérieur. Le conduit intérieur 3, qui sert à la circulation du fluide symbolisée par deux flèches F1 et F2, est branché à ses deux extrémités respectivement sur la pompe P et sur l'appareil U par des colliers filetés C1, C2 comportant des joints d'étanchéité non représentés quand au conduit extérieur 4 il est relié à la pompe P et à l'appareil U par des colliers D1, D2 formés chacun de deux coquilles assemblées par vis. Entre les bords de l'ouverture 2 et le conduit extérieur 4 un cordon de soudure continu, fermé sur lui-même, S1, assure une liaison étanche entre la paroi 1 et le conduit 4.

Du côté extérieur à l'enceinte E et à environ dix centimètres de la paroi 1, une rondelle en cuivre 5, perpendiculaire à la grande dimension des conduits 3 et 4, sépare l'espace compris entre ces conduits en deux zones distinctes A et B ; il est à noter que cette séparation aurait pu être placée en niveau de l'ouverture 2 ou de autre côté de la paroi 1. Pour permettre l'insertion de la rondelle 5, le conduit 4 est fait de deux tronçons de tube mis bout à bout au niveau de la rondelle deux cordons de soudure S2 et S3 assurent des liaisons étanches respectivement entre les extrémités en regard des deux tronçons de tube et le pourtour extérieur de la rondelle et entre le pourtour intérieur de la rondelle et le conduit intérieur.

Ainsi, par le montage selon la figure 1, est réalisée une liaison conductrice constituant un cloisonnement total entre les bords de l'ouverture 2 et le conduit intérieur 3 et assurant la protection électromagnétique de l'enceinte E.

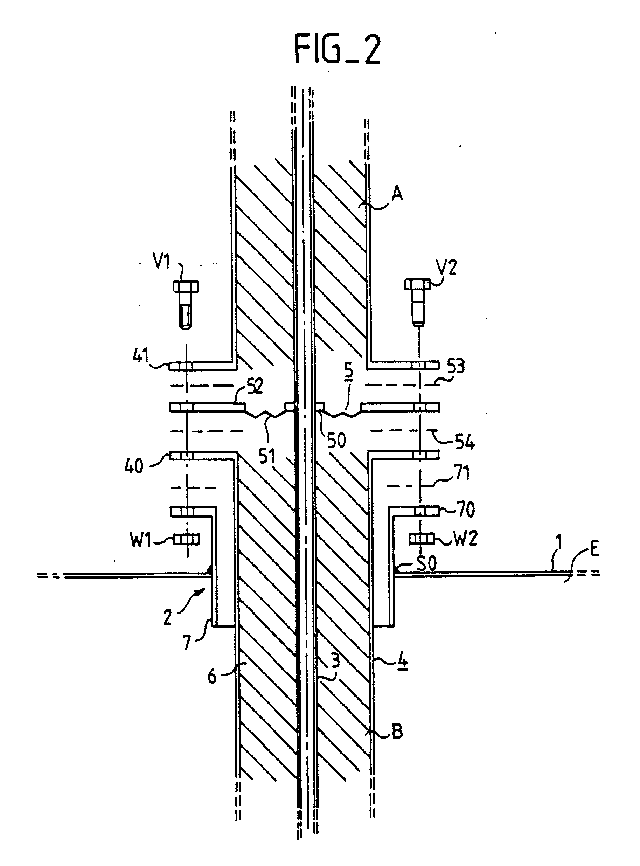

Le dispositif qui vient d'être décrit à l'aide de la figure 1 a été amélioré pour arriver au dispositif selon la figure 2 dont seule la partie située au voisinage de l'ouverture 2 de l'enceinte 1 a été représentée. L'amélioration a porté sur la facilité d'assemblage et de démontage obtenue, en particulier, par l'utilisation de brides de fixation tenues au moyen de vis ; l'amélioration a également porté sur une plus grande absorption des contraintes mécaniques au niveau où elles sont les plus sensibles, c'est-à-dire au niveau de la séparation en deux zones distinctes de l'espace compris entre les deux conduits.

La figure 2 montre, en coupe longitudinale, la paroi extérieure 1 d'une enceinte E. Cette paroi est percée d'une ouverture 2 à travers laquelle passe un dispositif de transfert de fluide selon l'invention ; ce dispositif, comme celui selon la figure 1, est destiné à permettre la circulation d'azote liquide de l'extérieur vers l'intérieur de l'enceinte E.

Un manchon 7, fait d'un tronçon de tube en acier inoxydable de 46 cm de long et 168 mm de diamètre, traverse le trou 2 sur les bords duquel il est fixé par un cordon de soudure continu, fermé sur lui-même, SO ; le manchon 7 comporte une bride de raccordement, 70, à son extrémité extérieure à l'enceinte E.

Le manchon 7 constitue un passage pour deux conduits coaxiaux, 3 et 4, séparés par un isolant thermique 6. Le conduit 3 est un conduit en cuivre de 14 mm de diamètre et le conduit 4 est un conduit en aluminium de 120 mm de diamètre. Le conduit intérieur 3 sert à la circulation de l'azote liquide et est constitué d'une seule pièce, tandis que le conduit extérieur 4 est constitué de deux sections de tuyau assemblées bout à bout grâce à des brides de raccordement 40, 41 qui terminent leurs extrémités en regard.

Le dispositif selon la figure 2 est représenté alors que les brides 70, 40 et 41 sont écartées les unes des autres, avec deux des huit ensembles vis-écrou, tels que V1-W1, V2-W2, régulièrement répartis sur une circonférence de 200 mn et destinés à assembler les brides. Entre les brides 40 et 41 est disposée une rondelle métallique 5 faite de trois anneaux concentriques, successifs, soudés les uns aux autres : une bague 50 entourant le conduit intérieur 3 sur la périphérie duquel elle est soudée par un cordon de soudure assurant une liaison étanche, un soufflet en alliage cuivreux 51 destiné à permettre à la rondelle 5 d'absorber des déformations mécaniques éventuelles et ainsi d'éviter d'endommager le conduit intérieur, et une collerette 52 percée de trous pour sa fixation par les ensembles vis-écrou tels que V1-W1, V2-W2, entre les brides 40, 41. La rondelle 5 sépare l'espace compris entre les conduits 3 et 4 en deux zones distinctes A et B.

La figure 2 montre également des joints radioélectriques 53, 54, 71 faits de toile métallique découpée en forme de collerette et disposés respectivement entre la bride 41 et la rondelle 5, entre la rondelle 5 et la bride 40 et entre les brides 40 et 70.

Ainsi les dispositifs selon les figures 1 et 2 présentent une combinaison de points communs pour assurer la traversée de la paroi d'une enceinte avec protection électromagnétique et protection contre les phénomènes thermiques ; ces points communs sont, en particulier, l'utilisation de deux conduits coaxiaux séparés par un matériau thermiquement isolant et la présence d'une cloison radioélectriquement étanche allant du conduit intérieur jusqu'aux bords de l'ouverture pratiquée dans l'enceinte pour le passage des conduits.

La présente invention n'est pas limitée aux réalisations décrites à l'aide des figures 1 et 2 ; elle s'étend à toutes les variantes accessibles à l'homme de métier et cela quelle que soit la température et la pression du fluide et même que ce fluide soit liquide ou gazeux. De plus comme le conduit extérieur ne participe que partiellement à la constitution de la cloison radioélectriquement étanche dont il a été question ci-avant, il peut n'être conducteur que dans sa partie constitutive de la cloison, par exemple la bride 40 de la figure 2. Le conduit extérieur peut même ne pas participer à la constitution de la cloison et alors ne pas posséder la moindre partie conductrice ; ce serait le cas avec la réalisation selon la figure 1 à condition que la rondelle 5 soit située au niveau de la paroi 1, ou, avec la réalisation de la figure 2, à condition de relier de façon radioélectriquement étanche le pourtour de la collerette 52 au pourtour de la bride 70 par exemple au moyen d'un joint radioélectrique en anneau, à cheval sur le pourtour de la bride 40.

## Revendications

1. Dispositif de transfert de fluide à travers une ouverture (2) percée dans la paroi extérieure (1) d'une enceinte (E), avec protection radioélectrique de l'intérieur de l'enceinte, caractérisé par un conduit extérieur (4) et un conduit intérieur (3) au moins sensiblement coaxiaux, le conduit intérieur étant conducteur et servant à la circulation du fluide, par un matériau thermiquement isolant (6), intercalé entre les deux conduits (3, 4), et par une cloison (4, 5 ; 4, 5, 7) radioélectriquement étanche allant des bords de l'ouverture (2) jusqu'au conduit intérieur (3) et comportant une séparation (5) disposée transversalement entre les deux conduits pour diviser en deux zones distinctes (A, B) la région située entre les deux conduits.

2. Dispositif selon la revendication 1, caractérisé en ce que le conduit extérieur (4) est formé de deux tubes conducteurs, dans le prolongement l'un de l'autre et comportant chacun, sur leurs extrémités en regard, une bride de fixation (40, 41) et en ce que la cloison comporte une collerette (52) intercalée entre les brides de fixation.

3. Dispositif selon l'une quelconque des revendications précédentes, caractérisé en ce que la séparation comporte un soufflet métallique (51) à pliures circulaires concentriques.

4. Dispositif selon la revendication 3, caractérisé en ce que la séparation comporte une bague (50) solidaire du conduit intérieur (3) et en ce que le soufflet (51) est solidaire de la bague (50).

5. Dispositif selon la revendication 1 caractérisé en ce qu'il comporte un manchon métallique (7), qui traverse l'ouverture, qui est solidaire des bords de l'ouverture (2) et qui entoure le conduit extérieur (4) et en ce que la séparation (5) est mécaniquement et électriquement couplée à la paroi extérieure (1) parle manchon (7) pour former la cloison (4, 5, 7).

6. Enceinte du type cage de Faraday, caractérisée en ce que sa paroi extérieure (1) est munie d'au moins un dispositif selon l'une quelconque des revendications précédentes.

FIG_1

# FIG_2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-3 781 724  (MOORE et al) <br> * Figure 5; col. 2, ligne 55 - col. 3, ligne 27 * <br> --- | 1 | F 16 L   59/14 <br> F 16 L   59/16 <br> H 05 K   9/00 <br> F 17 C   13/00 |
| A | US-A-3 625 018  (ROBERTS) <br> * Figure; Abrégé * <br> --- | 1 | |
| A | US-A-3 369 826  (BOOSEY et al) <br> * Figure 1; col. 3, ligne 11 - col. 5, ligne 37 * <br> ----- | 1-3 | |

| DOMAINES TECHNIQUES RECHERCHES (Int. Cl.5) |
|---|
| F 16 L <br> H 05 K <br> F 17 C |

Le présent rapport a été établi pour toutes les revendications

| Lieu de la recherche | Date d'achèvement de la recherche | Examinateur |
|---|---|---|
| LA HAYE | 16-01-1990 | NARMINIO A. |